# EUROPÄISCHE PATENTSCHRIFT

(11) **EP 3 526 616 B1**
(45) Veröffentlichungstag und Bekanntmachung des Hinweises auf die Patenterteilung: **07.12.2022**
(21) Anmeldenummer: 17780759.1
(22) Anmeldetag: 09.10.2017
(51) Int. Cl.: G01R 31/69

(54) **HAUSGERÄT MIT EINER STECKVERBINDUNG ZU EINEM NETZKABEL**
DOMESTIC APPLIANCE HAVING A PLUG-IN CONNECTION TO A MAINS CABLE
APPAREIL MÉNAGER MUNI D'UNE CONNEXION ENFICHABLE À UN CÂBLE D'ALIMENTATION

(30) Priorität: 13.10.2016 DE 102016219975
(43) Veröffentlichungstag der Anmeldung: 21.08.2019
(73) Patentinhaber: BSH Hausgeräte GmbH, 81739 München (DE)
(72) Erfinder: KÖPPL, Magnus, 93093 Donaustauf (DE); HELMSCHMIDT, Holger, 93047 Regensburg (DE)
(86) Internationale Anmeldenummer: PCT/EP2017/075666
(87) Internationale Veröffentlichungsnummer: WO 2018/069245

(56) Entgegenhaltungen:
- DE-U1-202014 101 858
- JP-A- 2012 008 028
- US-A- 5 434 509
- US-A1- 2004 024 545
- US-A1- 2005 212 526
- US-A1- 2008 211 683

## Beschreibung

Die Erfindung betrifft ein System mit einem Hausgerät, insbesondere einem Haushaltsgerät, und mit einem Netzkabel.

Ein Hausgerät, insbesondere ein Haushaltsgerät wie z.B. eine Waschmaschine, eine Spülmaschine, ein Wäschetrockner, etc., werden typischerweise über ein Netzkabel an ein elektrisches Versorgungsnetz angeschlossen, um das Hausgerät mit elektrischer Energie zu versorgen. Das Netzkabel umfasst dabei eine netzseitige Schnittstelleneinheit (insbesondere einen Netzstecker), mit dem das Netzkabel in eine Netzschnittstelle (insbesondere in eine Steckdose) gesteckt wird. Des Weiteren kann das Netzkabel eine geräteseitige Schnittstelleneinheit umfassen, mit dem das Netzkabel mit einer Geräteschnittstelle (insbesondere mit einem Stecker des Hausgeräts) verbunden wird.

Die geräteseitige Schnittstelleneinheit und die Geräteschnittstelle bilden typischerweise ein Stecksystem, wobei die Steckverbindung zwischen geräteseitiger Schnittstelleneinheit und Geräteschnittstelle durch einen Nutzer eines Hausgeräts hergestellt werden kann. Dabei kann es vorkommen, dass ein Nutzer die Steckverbindung nur unzureichend herstellt. Des Weiteren kann es vorkommen, dass aufgrund von Alterung und/oder Abnutzung die Qualität der Steckverbindung zwischen geräteseitiger Schnittstelleneinheit und Geräteschnittstelle unzureichend ist.

Hierzu offenbart die DE 20 2014 101 858 U1 ein Überwachungsmodul zur Schutzleiterüberwachung. Ferner offenbart die US 2008/0211683 A1 ein Verfahren und ein Gerät für eine Leitungsverbindungsüberwachung. Ferner offenbart die US2005/212526A1 ebenfalls ein Haushaltsgerät mit einem Netzkabel, um das Haushaltsgerät mit einem Versorgungsnetz zu verbinden.

Das vorliegende Dokument befasst sich mit der technischen Aufgabe, ein Hausgerät und ein System mit einem Hausgerät und einem Netzkabel bereitzustellen, mit denen die Güte bzw. der Zustand einer Steckverbindung zwischen Hausgerät und Netzkabel zuverlässig und präzise überwacht werden kann.

Die Aufgabe wird durch den Gegenstand des unabhängigen Patentanspruchs gelöst. Vorteilhafte Ausführungsformen sind insbesondere in den abhängigen Patentansprüchen definiert, in nachfolgender Beschreibung beschrieben oder in der beigefügten Zeichnung dargestellt.

Gemäß einem Aspekt der Erfindung wird ein Hausgerät, insbesondere ein Haushaltsgerät, beschrieben, das eine Geräteschnittstelle zum Anschluss eines Netzkabels sowie eine Steuereinheit umfasst. Das Hausgerät kann ausgebildet sein, um in einem Haushalt (insbesondere in einer Küche) durch einen Nutzer genutzt zu werden. Beispielhafte Hausgeräte sind Küchengeräte, wie z.B. ein Kühlschrank, eine Waschmaschine, eine Kaffeemaschine, ein Mixer, eine Küchenmaschine, etc.

Die Geräteschnittstelle ist eingerichtet, um mit einer geräteseitigen Schnittstelleneinheit des Netzkabels eine Steckverbindung zu bilden. Insbesondere können Leistungs-Kontaktteile der geräteseitigen Schnittstelleneinheit mit komplementären Leistungs-Kontaktteilen der Geräteschnittstelle Steckverbindungen bilden. Dabei kann bevorzugt ein Leistungs-Kontaktteil der geräteseitigen Schnittstelleneinheit eine Buchse umfassen, in die ein Stift der Geräteschnittstelle gesteckt werden kann. Insbesondere kann die Geräteschnittstelle als Stecker ausgebildet sein, der in eine als Steckdose ausgebildete geräteseitige Schnittstelleneinheit gesteckt werden kann.

Die Geräteschnittstelle umfasst somit Leistungs-Kontaktteile, die eingerichtet sind, mit Leistungs-Kontaktteilen der geräteseitigen Schnittstelleneinheit jeweils (paarweise) Leistungsverbindungen zu bilden, um das Hausgerät mit elektrischer Energie aus einem elektrischen Versorgungsnetz (z.B. aus einem 230V Netz) zu versorgen. Zu diesem Zweck kann das Netzkabel über eine netzseitige Schnittstelleneinheit (z.B. über einen Netzstecker) mit dem Versorgungsnetz (z.B. mit einer Steckdose des Versorgungsnetzes) verbunden werden. Dabei ist die netzseitige Schnittstelleneinheit typischerweise standardisiert (z.B. Stecker-Typ F (CEE 7/4)). Beispielhafte Leistungsverbindungen können für einen Neutralleiter und für einen Phasenleiter bereitgestellt werden.

Die geräteseitige Schnittstelleneinheit und die Geräteschnittstelle weisen Mess-Kontaktteile auf, um eine erste Messverbindung parallel zu einer ersten Leistungsverbindungen der Leistungsverbindungen zu bilden. Die Messverbindung kann dabei zusätzlich zu den Leistungsverbindungen bereitgestellt werden. Die geräteseitige Schnittstelleneinheit kann dann erste Mittel umfassen, die eingerichtet sind, über die erste Messverbindung Information in Bezug auf einen Übergangswiderstand der ersten Leistungsverbindung zu erfassen und über die Signalleitung bereitzustellen. Insbesondere kann durch die parallele Anordnung der ersten Messverbindung und der ersten Leistungsverbindung Information in Bezug auf einen Spannungsabfall an der ersten Leistungsverbindung erfasst und bereitgestellt werden.

Die Geräteschnittstelle ist eingerichtet, mittels eines Signals auf einer Signalleitung eine Güte der Steckverbindung zwischen Geräteschnittstelle und geräteseitiger Schnittstelleneinheit anzuzeigen. Insbesondere kann die Geräteschnittstelle neben den Leitungen für die Leistungsverbindungen (insbesondere neben einem Neutralleiter, einem Phasenleiter und ggf. einem Schutzleiter) noch eine Signalleitung umfassen, auf der die Güte der Steckverbindung zwischen Geräteschnittstelle und geräteseitiger Schnittstelleneinheit angezeigt werden kann. Das Signal auf der Signalleitung kann dabei abhängig sein von: einem Übergangswiderstand zumindest einer der Leistungsverbindungen; einer Wärmeentwicklung an zumindest einer der Leistungsverbindungen und/oder einem Überlappungsgrad zwischen den Leistungs-Kontaktteilen der geräteseitigen Schnittstelleneinheit und den Leistungs-Kontaktteilen der Geräteschnittstelle.

Die Steuereinheit kann eingerichtet sein, in Abhängigkeit von dem Signal auf der Signalleitung, im Hausgerät (zumindest) eine Maßnahme in Bezug auf die Güte der Steckverbindung zu veranlassen. Beispielhafte Maßnahmen sind dabei: das Ausgeben eines Hinweises in Bezug auf die Güte der Steckverbindung über eine Ausgabeeinheit (z.B. auf einem Bildschirm) des Hausgeräts; das Reduzieren einer Leistungsaufnahme des Hausgeräts über die Leistungsverbindungen; und/oder das Überführen des Hausgeräts in einen sicheren Betriebszustand.

Das Hausgerät kann somit eingerichtet sein, die Güte der Steckverbindung zu einem Netzkabel zu überwachen und bei Bedarf Gegenmaßnahmen einzuleiten. So können die Sicherheit, die Zuverlässigkeit und der Komfort eines Hausgeräts weiter erhöht werden.

Gemäß einem weiteren Aspekt der Erfindung wird ein System mit einem Hausgerät und einem Netzkabel beschrieben. Dabei kann das Hausgerät wie in diesem Dokument beschrieben ausgebildet sein. Das Netzkabel umfasst eine geräteseitige Schnittstelleneinheit, die über Leitungen mit einer netzseitigen Schnittstelleneinheit zum Anschluss des Netzkabels an ein elektrisches Versorgungsnetz verbunden ist. Das Hausgerät kann somit über das Netzkabel an das elektrische Versorgungsnetz angeschlossen werden. Zu diesem Zweck umfasst die geräteseitige Schnittstelleneinheit des Netzkabels Leitungs-Kontaktteile, die eingerichtet sind, mit Leistungs-Kontaktteilen der Geräteschnittstelle Leistungsverbindungen zu bilden.

Die geräteseitige Schnittstelleneinheit und die Geräteschnittstelle umfassen Mittel, mit denen Information in Bezug auf die Güte der Steckverbindung zwischen der geräteseitigen Schnittstelleneinheit und der Geräteschnittstelle erfasst und über die Signalleitung der Geräteschnittstelle angezeigt werden kann. Insbesondere kann Information in Bezug auf den Übergangswiderstand zumindest einer der Leistungsverbindungen; Information in Bezug auf die Wärmeentwicklung an zumindest einer der Leistungsverbindungen und/oder Information in Bezug auf den Überlappungsgrad zwischen den Leistungs-Kontaktteilen der geräteseitigen Schnittstelleneinheit und den Leistungs-Kontaktteilen der Geräteschnittstelle erfasst und über die Signalleitung der Geräteschnittstelle angezeigt werden.

Beispielsweise können die ersten Mittel einen ersten Optokoppler umfassen, der in einem Strang parallel zu der ersten Leistungsverbindung und in Reihe zu der Messverbindung angeordnet ist. Der erste Optokoppler kann eine Lichtquelle (z.B. eine Photodiode) umfassen, die eingerichtet ist, eine Menge an Licht zu generieren, die abhängig von dem Übergangswiderstand der ersten Leistungsverbindung (bzw. abhängig von dem Spannungsabfall an der ersten Leistungsverbindung) ist. Des Weiteren kann der erste Optokoppler einen Phototransistor umfassen, der eingerichtet ist, das von der Lichtquelle generierte Licht zu empfangen und einen Durchlass-Widerstand des Phototransistors in Abhängigkeit von der empfangenen Menge an Licht zu ändern. Außerdem kann der Phototransistor angeordnet sein, um die Signalleitung über den Durchlass-Widerstand mit einer Referenzleitung zu koppeln. An der Referenzleitung kann z.B. ein Referenzpotential bereitgestellt werden, so dass das Potential und/oder der Strom auf der Signalleitung den Übergangswiderstand der ersten Leistungsverbindung anzeigt. Durch die Verwendung eines Optokopplers kann eine galvanische Trennung zwischen Signalleitung und den Leistungsverbindungen bereitgestellt werden. Des Weiteren wird so eine effiziente und präzise Ermittlung des Übergangswiderstands der ersten Leistungsverbindung (und damit der Güte der Steckverbindung) ermöglicht.

Die geräteseitige Schnittstelleneinheit und die Geräteschnittstelle können weitere Mess-Kontaktteile aufweisen, um eine zweite Messverbindung parallel zu einer zweiten Leistungsverbindungen der Leistungsverbindungen aufzubauen. Die geräteseitige Schnittstelleneinheit kann zweite Mittel umfassen (die entsprechend zu den ersten Mitteln ausgelegt sein können), die eingerichtet sind, über die zweite Messverbindung Information in Bezug auf einen Übergangswiderstand der zweiten Leistungsverbindung zu erfassen. Außerdem kann die geräteseitige Schnittstelleneinheit Kombinations-Elektronik (z.B. Logik-Komponenten) umfassen, die eingerichtet ist, die Information in Bezug auf den Übergangswiderstand der ersten Leistungsverbindung und die Information in Bezug auf den Übergangswiderstand der zweiten Leistungsverbindung zu kombinieren und (in Kombination) über die Signalleitung bereitzustellen. So kann in effizienter Weise Information über die Güte der Steckverbindung bereitgestellt werden.

Die geräteseitige Schnittstelleneinheit kann einen Temperatursensor umfassen, der thermisch mit zumindest einer der Leistungsverbindungen gekoppelt ist. Die Signalleitung kann dann Information in Bezug auf eine Temperatur des Temperatursensors (als Information in Bezug auf die Güte der Steckverbindung) anzeigen. Insbesondere können die geräteseitige Schnittstelleneinheit und die Geräteschnittstelle Referenz-Kontaktteile aufweisen, über die die geräteseitige Schnittstelleneinheit mit einer Referenzleitung der Geräteschnittstelle verbunden werden kann. Die Referenzleitung kann sich z.B. auf einem Referenzpotential befinden. Der Temperatursensor kann dann einen temperaturabhängigen Widerstand umfassen, der die Signalleitung mit der Referenzleitung verbindet. So kann in effizienter und präziser Weise Information in Bezug auf die Wärmeentwicklung an zumindest einer Leistungsverbindung bereitgestellt werden.

Die geräteseitige Schnittstelleneinheit und die Geräteschnittstelle können somit Referenz-Kontaktteile aufweisen, über die die geräteseitige Schnittstelleneinheit mit einer Referenzleitung der Geräteschnittstelle verbunden werden kann (wobei die Referenzleitung z.B. auf einem Referenzpotential liegt). Des Weiteren können die geräteseitige Schnittstelleneinheit und die Geräteschnittstelle Signal-Kontaktteile aufweisen, über die die geräteseitige Schnittstelleneinheit mit der Signalleitung der Geräteschnittstelle verbunden werden kann. Die Referenz-Kontaktteile und Signal-Kontaktteile können dabei z.B. als Federkontakte ausgebildet sein. Die geräteseitige Schnittstelleneinheit kann eine elektrisch leitfähige Kontaktbrücke (z.B. eine Platte) umfassen, mit der die Signalleitung mit der Referenzleitung verbunden werden kann, wenn der Überlappungsgrad zwischen den Leistungs-Kontaktteilen der geräteseitigen Schnittstelleneinheit und den Leistungs-Kontaktteilen der Geräteschnittstelle einen vordefinierten Überlappungsgrad-Schwellenwert erreicht oder überschreitet. Die Steckverbindung kann z.B. einen maximalen Überlappungsgrad der Leistungs-Kontaktteile ermöglichen. Der Überlappungsgrad-Schwellenwert kann z.B. 80%, 90% oder mehr des maximalen Überlappungsgrads sein. Es kann somit in effizienter und präziser Weise ermittelt werden, ob eine Steckverbindung ausreichend gesteckt ist oder nicht.

Die Geräteschnittstelle umfasst gemäß der vorliegenden Erfindung eine Lichtquelle (z.B. eine Photodiode), die eingerichtet ist, Licht zu emittieren. Des Weiteren kann die Geräteschnittstelle einen Phototransistor umfassen, der eingerichtet ist, die Signalleitung in Abhängigkeit von einer erfassten Menge an Licht mit einer Referenzleitung zu koppeln oder von der Referenzleitung zu entkoppeln (wobei die Referenzleitung z.B. auf einem Referenzpotential liegt). Insbesondere kann der Durchlass-Widerstand des Phototransistors in Abhängigkeit von der erfassten Menge an Licht angepasst werden.

Die geräteseitige Schnittstelleneinheit und die Geräteschnittstelle sind dann derart ausgebildet, dass die Menge an Licht der Lichtquelle, die von dem Phototransistor erfasst wird, von dem Überlappungsgrad zwischen den Leistungs-Kontaktteilen der geräteseitigen Schnittstelleneinheit und den Leistungs-Kontaktteilen der Geräteschnittstelle abhängt. So kann auch ohne Bereitstellung von zusätzlichen Kontaktteilen für die Signalleitung und für die Referenzleitung die Güte der Steckverbindung ermittelt werden.

Die geräteseitige Schnittstelleneinheit umfasst eine reflektierende Schicht (z.B. eine Platte), die eingerichtet ist, Licht von der Lichtquelle zu dem Phototransistor zu reflektieren, wenn der Überlappungsgrad zwischen den Leistungs-Kontaktteilen der geräteseitigen Schnittstelleneinheit und den Leistungs-Kontaktteilen der Geräteschnittstelle einen vordefinierten Überlappungsgrad-Schwellenwert erreicht oder überschreitet.

Alternativ oder ergänzend kann die Geräteschnittstelle eine Senke aufweisen, in die bei Herstellung der Steckverbindung zwischen der Geräteschnittstelle und der geräteseitigen Schnittstelleneinheit eine Nase der geräteseitigen Schnittstelleneinheit eintaucht. Die Lichtquelle und der Phototransistor können derart angeordnet sein, dass von der Lichtquelle emittiertes Licht quer durch die Senke zu dem Phototransistor gelangt. Des Weiteren können die Nase und die Senke derart ausgebildet sein, dass die Nase Licht, das von der Lichtquelle emittiert wurde, von dem Phototransistor abschirmt, wenn der Überlappungsgrad zwischen den Leistungs-Kontaktteilen der geräteseitigen Schnittstelleneinheit und den Leistungs-Kontaktteilen der Geräteschnittstelle einen vordefinierten Überlappungsgrad-Schwellenwert erreicht oder überschreitet.

Es ist zu beachten, dass jegliche Aspekte des in diesem Dokument beschriebenen Hausgeräts und/oder Systems in vielfältiger Weise miteinander kombiniert werden können. Insbesondere können die Merkmale der Patentansprüche in vielfältiger Weise miteinander kombiniert werden.

Im Weiteren wird die Erfindung anhand von in der beigefügten Zeichnung dargestellten Ausführungsbeispielen näher beschrieben. Dabei zeigen
- Figur 1: ein Blockdiagramm eines Hausgeräts und eines Netzkabels;
- Figur 2a: ein beispielhaftes Stecksystem mit Mitteln zur Ermittlung von Information in Bezug auf einen Übergangswiderstand von Kontaktteilen des Stecksystems;
- Figur 2b: ein beispielhaftes Stecksystem mit Mitteln zur Ermittlung von Information in Bezug auf eine Temperatur von Kontaktteilen des Stecksystems;
- Figur 3a: ein beispielhaftes Stecksystem mit Mitteln zur Ermittlung von Information in Bezug auf eine relative Stellung von Kontaktteilen des Stecksystems;
- Figur 3b: ein beispielhaftes Stecksystem mit weiteren Mitteln zur Ermittlung von Information in Bezug auf eine relative Stellung von Kontaktteilen des Stecksystems; und
- Figur 3c: ein beispielhaftes Stecksystem mit weiteren Mitteln zur Ermittlung von Information in Bezug auf eine relative Stellung von Kontaktteilen des Stecksystems.

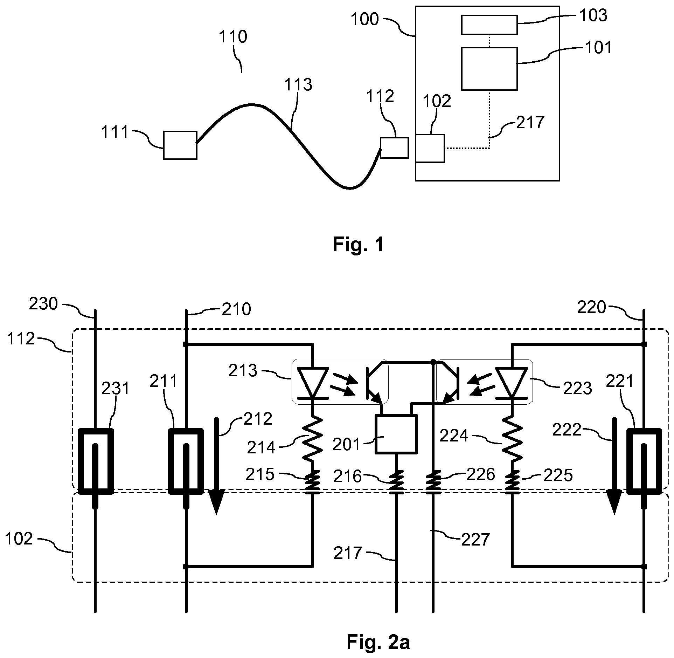

Wie eingangs dargelegt, befasst sich das vorliegende Dokument mit der zuverlässigen und präzisen Überwachung einer Steckverbindung zwischen einem Netzkabel und einem Hausgerät. Fig. 1 zeigt ein Hausgerät 100, das über eine Geräteschnittstelle 102 (z.B. einen Stecker) mit der geräteseitigen Schnittstelleneinheit 112 (z.B. einer Buchse) eines Netzkabels 110 verbunden werden kann. Das Netzkabel 110 umfasst elektrische Leitungen 113, die die geräteseitige Schnittstelleneinheit 112 mit einer netzseitigen Schnittstelleneinheit 111 verbindet. Das Hausgerät 100 umfasst eine Steuereinheit 101, die eingerichtet ist, Information in Bezug auf eine Steckverbindung zwischen geräteseitiger Schnittstelleneinheit 112 und Geräteschnittstelle 102 von der Geräteschnittstelle 102 zu empfangen (über eine Signalleitung 217). Die Steuereinheit 101 ist weiter eingerichtet, das Hausgerät 100 in Abhängigkeit von der empfangenen Information zu steuern. Beispielsweise kann über eine Ausgabeeinheit 103 des Hausgeräts 100 ein optisches und/oder ein akustisches Signal ausgeben werden, um einen Nutzer des Hausgeräts 100 über den Zustand bzw. über die Güte der Steckverbindung zu informieren.

Die Steckverbindung zwischen der geräteseitigen Schnittstelleneinheit 112 und der Geräteschnittstelle 102 kann Mittel umfassen, mit denen der Zustand der Steckverbindung ermittelt und angezeigt werden kann. Fig. 2a zeigt beispielhafte Mittel, mit denen Information in Bezug auf einen Übergangswiderstand zwischen Kontaktteilen der Steckverbindung ermittelt und angezeigt werden kann.

Die Steckverbindung ist eingerichtet, mehrere Leistungsverbindungen 211, 221, 231 herzustellen, um elektrische Energie für die Energieversorgung des Hausgeräts 100 zu übertragen. Insbesondere kann eine Leistungsverbindung 211 für einen Neutralleiter N 210, eine Leistungsverbindung 221 für einen Phasenleiter 220 und eine Leistungsverbindung 231 für einen Schutzleiter 230 hergestellt werden. Die Geräteschnittstelle 102 und die geräteseitige Schnittstelleneinheit 112 umfassen dazu jeweils Kontaktteile. In dem dargestellten Beispiel umfasst die Geräteschnittstelle 102 Pins bzw. Stifte, die in entsprechende Buchsen der geräteseitigen Schnittstelleneinheit 112 gesteckt werden können, um die jeweiligen Leistungsverbindungen 211, 221, 231 herzustellen.

Aufgrund einer unzureichenden elektrischen Kontaktierung der Kontaktteile einer Leistungsverbindung 211, 221, 231 kann es zu einem erhöhten Übergangswiderstand an den Kontaktteilen kommen. Dies führt bei dem Neutralleiter 210 zu einer Neutralleiter-Spannung 212 und bei dem Phasenleiter 220 zu einer Phasenleiter-Spannung 222. Ein hoher Übergangswiderstand kann zu einer Erwärmung und damit zu einer Schädigung der Steckverbindung führen. Die in Fig. 2a dargestellte Steckverbindung umfasst Mittel, mit denen Information in Bezug auf die Spannungen 212, 222 auf einer Signalleitung 217 an die Steuereinheit 101 übermittelt werden kann. Insbesondere umfasst die Steckverbindung zusätzliche Kontaktteile-Paare für zusätzliche Verbindungen 215, 216, 226, 225 zwischen der geräteseitigen Schnittstelleneinheit 112 und der Geräteschnittstelle 102. Über eine erste Messverbindung 215 kann eine erste Messstrecke parallel zu der Neutralleiter-Verbindung 211 angeordnet werden. Die erste Messstrecke umfasst einen ersten Optokoppler 213, dessen Ausgangs-Transistor in Abhängigkeit von der Neutralleiter-Spannung 212 geöffnet oder geschlossen wird. Der erste Widerstand 214 dient dabei zur Einstellung eines Arbeitspunktes des ersten Optokopplers 213 sowie zur Begrenzung des Stroms durch die Leuchtdiode des ersten Optokopplers 213. In analoger Weise kann über die zweite Messverbindung 225 eine zweite Messstrecke mit einem zweiten Optokoppler 223 und einem zweiten Widerstand 224 bereitgestellt werden, wobei der Ausgangs-Transistor des zweiten Optokopplers 223 in Abhängigkeit von der Phasenleiter-Spannung 222 geöffnet bzw. geschlossen wird. Die Signalleitung 217 kann über eine Signalverbindung 216 mit den Emittoren der Ausgangs-Transistoren der Optokoppler 213, 223 gekoppelt werden (ggf. indirekt über eine Logik-Einheit 201). Über die Referenzverbindung 226 können die Kollektoren der Ausgangs-Transistoren der Optokoppler 213, 223 mit einer Referenzleitung 227 gekoppelt werden (die z.B. auf einer Referenzspannung VCC liegt (z.B. VCC=5V)). Der Strom und/oder das Potential auf der Signalleitung 217 zeigt somit die Höhe der Spannungen 212, 222 und folglich die Höhe der Übergangswiderstände der Leistungsverbindungen 211, 221 an.

Die über die Leistungsverbindungen 211, 221 abfallenden Spannungen 212, 222 können somit mittels der Optokoppler 213, 223 als Signal weitergegeben werden. Die Optokoppler 213, 223 sorgen dabei für eine galvanische Trennung des Signals von der Versorgungsspannung auf dem Neutralleiter 210 und auf dem Phasenleiter 220. Dabei erzeugt ein höherer Spannungsabfall ein stärkeres Ausgangssignal der Optokoppler 213, 223. Ein höherer Spannungsabfall bedeutet typischerweise eine erhöhte Temperatur der Leistungsverbindungen 211, 221 (da die Pᵥₑᵣₗᵤₛₜ = U kontakt * I ist). Somit wird indirekt über den Spannungsabfall an den Leistungsverbindungen 211, 221 eine Messung der Temperatur ermöglicht. Die beiden Signale an den Ausgangs-Transistoren können ggf. direkt zu einem einzigen Signal auf der Signalleitung 217 verbunden werden. Optional kann auch eine logische Verknüpfung in der Logik-Einheit 201 erfolgen. Das Signal kann von der Steuereinheit 101 des Hausgeräts 100 ausgewertet werden (z.B. um eine Warnmeldung an einen Nutzer auszugeben, oder um die Last des Hausgeräts 100 zu reduzieren).

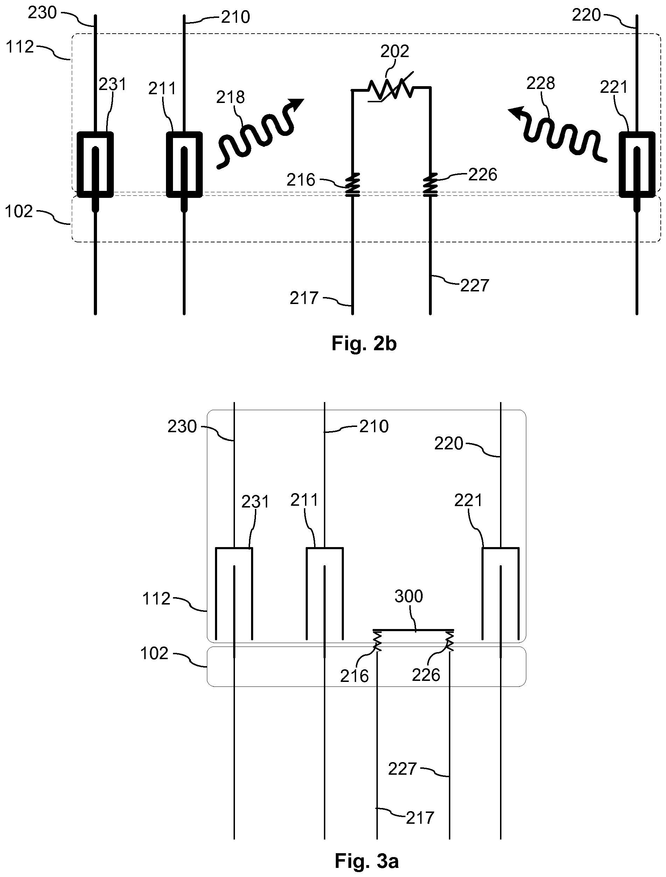

Fig. 2b veranschaulicht eine Steckverbindung, bei der über die Signalverbindung 216 und die Referenzverbindung 226 ein temperaturabhängiger Widerstand 202 (z.B. ein negativ temperature coefficient, NTC, oder ein positive temperature coefficient, PTC, Widerstand) in der geräteseitigen Schnittstelleneinheit 112 des Netzkabels 110 an die Signalleitung 217 angeschlossen ist. Durch die Wärme 218, 228 an den Leistungsverbindungen 211, 221 wird der Widerstand 202 erwärmt und ändert dabei seinen Widerstandswert. Die daraus resultierende Änderung des Stroms und/oder der Spannung auf der Signalleitung 217 ist somit ein Indikator für die Temperatur an den Leistungsverbindungen 211, 221. Die Signalverbindung 216 und die Referenzverbindung 226 können ggf. relativ hochohmig ausgeführt werden (z.B. über Federkontakte).

In der geräteseitigen Schnittstelleneinheit 112 kann somit ein Temperatursensor 202 eingebettet sein. Durch die Erwärmung zumindest einer Leistungsverbindung 211, 221 werden die elektrischen Eigenschaften dieses Temperatursensors 202 (z.B. der Widerstandswert) verändert. Diese Veränderung kann über die Signalleitung 217 an die Steuereinheit 101 weitergegeben und ausgewertet werden. Die Steuereinheit 101 kann die Erwärmung an einen Nutzer melden oder selbstständig weitere Schritte einleiten (z.B. Abschaltung von Verbrauchern des Hausgeräts 100, etc.). Bei dem Aufbau aus Fig. 2b ist die Signalleitung 217 galvanisch von der Versorgung des Hausgeräts 100 getrennt.

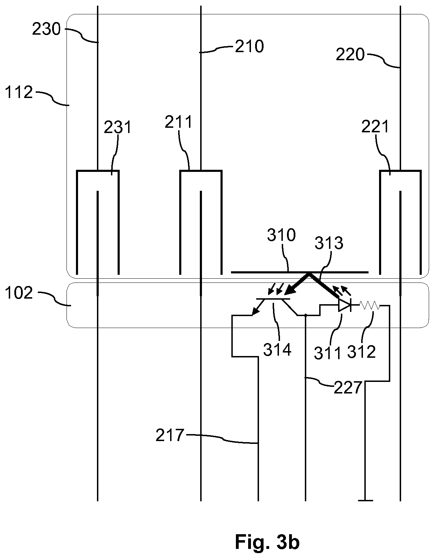

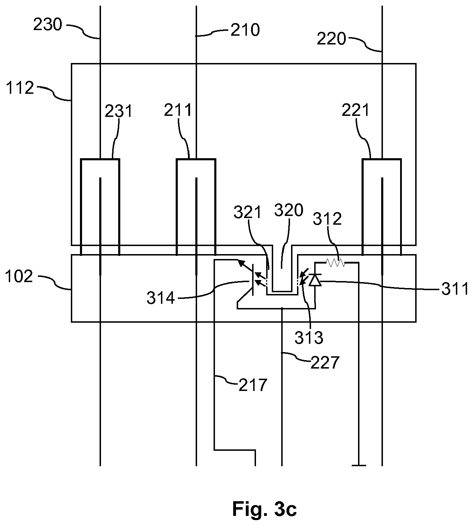

Ein relativ hoher Übergangswiderstand an den Leistungsverbindungen 211, 221 kann auch durch ein unzureichendes Stecken der Steckverbindung verursacht werden. In den Figuren 3a, 3b, 3c sind Mittel beschrieben, mit denen überwacht werden kann, ob die geräteseitige Schnittstelleneinheit 112 ausreichend vollständig in die Geräteschnittstelle 102 gesteckt wurde (oder umgekehrt). Die Steckverbindung aus Fig. 3a umfasst eine Kontaktplatte 300 innerhalb der geräteseitigen Schnittstelleneinheit 112, über die die Signalleitung 217 und die Referenzleitung 227 kurzgeschlossen werden können. Die Referenzleitung 227 kann z.B. mit einer Referenzspannung VCC gekoppelt sein. Die Spannung auf der Signalleitung 217 zeigt dann an, ob die Steckverbindung ausreichend gesteckt ist oder nicht. Die Signalverbindung 216 und die Referenzverbindung 226 zwischen Geräteschnittstelle 102 und geräteseitiger Schnittstelleneinheit 112 können z.B. Federkontakte aufweisen.

Ein unzureichender Steckvorgang, bei dem keine haptische Rückmeldung für eine unzureichende Steckverbindung erfolgt, kann zu einem relativ hohen Übergangswiderstand führen, der sich thermisch negativ auf das Stecksystem auswirkt. Die Kontaktplatte 300, welche nacheilend in der geräteseitigen Schnittstelleneinheit 112 verbaut ist, kann zwei Federkontakte der Signalverbindung 216 und der Referenzverbindung 226 überbrücken, welche in der Geräteschnittstelle 102 integriert sein können. Diese Federkontakte werden erst kontaktiert, wenn ein Zustand einer vollständigen Steckverbindung erreicht wird. Somit kann über die Signalleitung 217 erkannt werden, ob eine vollständige Steckverbindung vorliegt oder nicht. So kann vermieden werden, dass das Hausgerät 100 aufgrund einer ungenügenden Steckverbindung nicht mit ausreichend Leistung versorgt wird, um voll funktionsfähig zu agieren. Bei einer unvollständigen Steckverbindung werden die Federkontakte nicht überbrückt, so dass auf der Signalleitung 217 keine Spannung anliegt. Die Steuereinheit 101 kann daraufhin veranlassen, dass eine Fehlermeldung an einem Display 103 des Hausgeräts 100 angezeigt wird, mit der Aufforderung die Steckverbindung zu überprüfen. Des Weiteren kann die Leistungsaufnahme des Hausgeräts 100 reduziert werden (z.B. durch Deaktivieren von Verbrauchern), um das Hausgerät 100 in einen sicheren Betriebszustand zu überführen.

Die Steckverbindung aus Fig. 3b benötigt keine elektrischen Signalverbindung 216 oder Referenzverbindung 226 zwischen der Geräteschnittstelle 102 und der geräteseitigen Schnittstelleneinheit 112 des Netzkabels 110. Die geräteseitige Schnittstelleneinheit 112 umfasst eine Reflektionsplatte 310, die eingerichtet ist, Licht zu reflektieren. Die Geräteschnittstelle 102 umfasst eine Leuchtdiode 311 (ggf. mit einem StrombegrenzungsWiderstand 312), die an die Referenzleitung 227 angeschlossen ist und Licht 313 emittiert. Außerdem umfasst die Geräteschnittstelle 102 einen Phototransistor 314, der eingerichtet ist, einen Durchlass-Widerstand des Phototransistors 314 in Abhängigkeit von einer erfassten Menge an Licht zu verändert. Der Phototransistor 314 verbindet die Signalleitung 303 mit der Referenzleitung 227. Die Reflektionsplatte 310, die Leuchtdiode 311 und der Phototransistor 314 sind derart angeordnet, dass im vollständig gesteckten Zustand das Licht 313 der Photodiode 311 möglichst umfassend auf den Phototransistor 314 reflektiert wird, so dass der Transistor 314 öffnet und die Signalleitung 303 mit der Referenzleitung 227 verbindet (die z.B. auf einem Referenzpotential VCC liegt). Andererseits erreicht bei einer unzureichenden Steckverbindung kein substantieller Anteil des Lichts 313 den Phototransistor 314, so dass die Signalleitung 303 von der Referenzleitung 227 getrennt ist.

Über einen optischen Signalgeber 311, der in der Geräteschnittstelle 102 verbaut ist, kann ein definiertes Lichtsignal 313 ausgegeben werden, welches über einen bestimmten Winkel α und/oder mit einer definierten Intensität an der Reflexionsplatte 310 (oder einer entsprechend funktionellen Oberfläche), die in der geräteseitigen Schnittstelleneinheit 112 lokal unabhängig verbaut ist, reflektiert wird. Dieses (reflektierte) optische Signal 313 wird von einem Phototransistor 314, welcher ebenfalls der Geräteschnittstelle 102 oder auf der Elektronik des Hausgeräts 100 verbaut ist, empfangen. Die Intensität des optischen Signals 313, welches am Phototransistor 314 empfangen wird, hängt von dem Reflexionswinkel (α) und/oder von dem Abstand zur reflektierenden Oberfläche 310 ab. Bei einem bestimmten Winkel α und/oder bei einem bestimmten Abstand liegt am Phototransistor 314 eine definierte Lichtintensität vor, die anzeigt, dass der Steckvorgang optimal ausgeführt wurde. Bei einer reduzierten Lichtintensität kann auf eine unzureichende Steckverbindung geschlossen werden. In Reaktion darauf kann eine Fehlermeldung im Hausgerät 100 angezeigt werden, Last reduziert werden und/oder eine Überführung des Hausgeräts 100 in einen sicheren Zustand erfolgen.

Fig. 3c zeigt eine ähnliche Anordnung wie Fig. 3b. Die geräteseitige Schnittstelleneinheit 112 umfasst eine Nase 320, die in eine Senke 321 der Geräteschnittstelle 102 hineinragt. Die Photodiode 311 ist derart angeordnet, dass Licht 313 auf einer Seite der Senke 321 ausgestrahlt und auf einer anderen Seite der Senke 321 von dem Phototransistor 314 erfasst wird. Durch die Nase 320 kann das Licht 313 blockiert werden (bei ausreichender Güte der Steckverbindung), so dass der Phototransistor 314 kein Licht 313 (oder eine reduzierte Menge von Licht 313) erfasst. Andererseits wird das Licht 313 bei unzureichender Güte der Steckverbindung nicht substantiell blockiert, was von dem Phototransistor 314 erfasst werden kann.

An der geräteseitigen Schnittstelleneinheit 112 kann somit eine Nase 320 angeordnet sein, die in eine Senke 321 in der Geräteschnittstelle 102 eintaucht. Die Senke 321 ist mit einem Durchgangsloch versehen und der optische Signalgeber 311 sendet ein Lichtsignal 313 durch diese Öffnung an den Phototransistor 314. Wenn dieses Signal durch die Nase 320 unterbrochen wird (Lichtschranke geschlossen), ist ein optimaler Steckvorgang erfolgt. Bei einem unzureichenden Steckvorgang wird die Lichtschranke nicht unterbrochen. In diesem Fall kann eine Fehlermeldung am Display 103 des Hausgeräts 100 angezeigt werden.

Mit den in diesem Dokument beschriebenen Maßnahmen kann die Güte einer Steckverbindung an einem Hausgerät in zuverlässiger und präziser Weise überwacht werden. So kann eine übermäßige Erwärmung der Steckverbindung verhindert werden. Die beschriebenen Maßnahmen weisen eine galvanische Trennung zu der Geräteversorgung auf und sind somit in sicherer Weise umsetzbar. Das Vorliegen einer unzureichenden Güte der Steckverbindung kann einem Nutzer an einer Ausgabeeinheit 103 des Hausgeräts 100 angezeigt werden, so dass der Nutzer geeignete Gegenmaßnahmen ergreifen kann. Des Weiteren können automatisch Maßnahmen im Hausgerät 100 umgesetzt werden, um das Hausgerät 100 in einem sicheren Betriebszustand zu überführen.

Die vorliegende Erfindung ist nicht auf die gezeigten Ausführungsbeispiele aber durch die Ansprüche beschränkt.

Insbesondere ist zu beachten, dass die Beschreibung und die Figuren nur das Prinzip des vorgeschlagenen Hausgeräts und/oder Systems veranschaulichen sollen.

## Patentansprüche

1. System mit einem Hausgerät (100) und einem Netzkabel (110), wobei
- das Netzkabel (110) eine geräteseitige Schnittstelleneinheit (112) umfasst, die über Leitungen (113) mit einer netzseitigen Schnittstelleneinheit (111) zum Anschluss des Netzkabels (110) an ein elektrisches Versorgungsnetz verbunden ist;
- das Hausgerät (100) eine Geräteschnittstelle (102) zum Anschluss des Netzkabels (110) und eine Steuereinheit (101) umfasst; wobei
- die Geräteschnittstelle (102) eingerichtet ist, mit der geräteseitigen Schnittstelleneinheit (112) des Netzkabels (110) eine Steckverbindung zu bilden;
- die Geräteschnittstelle (102) Leistungs-Kontaktteile umfasst, die eingerichtet sind, mit Leistungs-Kontaktteilen der geräteseitigen Schnittstelleneinheit (112) Leistungsverbindungen (211, 221) zu bilden, um das Hausgerät (100) mit elektrischer Energie aus einem elektrischen Versorgungsnetz zu versorgen;
- die Geräteschnittstelle (102) eingerichtet ist, mittels eines Signals auf einer Signalleitung (217) eine Güte der Steckverbindung zwischen Geräteschnittstelle (102) und geräteseitiger Schnittstelleneinheit (112) anzuzeigen; und
- die Steuereinheit (101) eingerichtet ist, in Abhängigkeit von dem Signal, im Hausgerät (100) eine Maßnahme in Bezug auf die Güte der Steckverbindung zu veranlassen; und
- die geräteseitige Schnittstelleneinheit (112) des Netzkabels (110) Leistungs-Kontaktteile umfasst, die eingerichtet sind, mit den Leistungs-Kontaktteilen der Geräteschnittstelle (102) die Leistungsverbindungen (211, 221) zu bilden, und wobei
- die geräteseitige Schnittstelleneinheit (112) und die Geräteschnittstelle (102) Mess-Kontaktteile aufweisen, um eine erste Messverbindung (215) parallel zur ersten Leistungsverbindung (211) der Leistungsverbindungen (211, 221) zu bilden, und die geräteseitige Schnittstelleneinheit (112) erste Mittel (213) umfasst, die eingerichtet sind, über die erste Messverbindung (225) Information in Bezug auf einen Übergangswiderstand der ersten Leistungsverbindung (211) zu erfassen und über die Signalleitung (217) bereitzustellen, **dadurch gekennzeichnet, dass**
- die Geräteschnittstelle (102) eine Lichtquelle (311) umfasst, die eingerichtet ist, Licht (313) zu emittieren; und dass
- die Geräteschnittstelle (102) einen Phototransistor (314) umfasst, der eingerichtet ist, die Signalleitung (217) in Abhängigkeit von einer erfassten Menge an Licht (313) mit einer Referenzleitung (227) zu koppeln oder von der Referenzleitung (227) zu entkoppeln; und dass
- die geräteseitige Schnittstelleneinheit (112) und die Geräteschnittstelle (102) derart ausgebildet sind, dass die Menge an Licht (313) der Lichtquelle (311), die von dem Phototransistor (314) erfasst wird, von einem Überlappungsgrad zwischen den Leistungs-Kontaktteilen der geräteseitigen Schnittstelleneinheit (112) und den Leistungs-Kontaktteilen der Geräteschnittstelle (102) abhängt, und
- wobei die geräteseitige Schnittstelleneinheit (112) eine reflektierende Schicht (310) aufweist, die eingerichtet ist, Licht (313) von der Lichtquelle (311) an den Phototransistor (314) zu reflektieren, wenn der Überlappungsgrad zwischen den Leistungs-Kontaktteilen der geräteseitigen Schnittstelleneinheit (112) und den Leistungs-Kontaktteilen der Geräteschnittstelle (102) einen vordefinierten Überlappungsgrad-Schwellenwert erreicht oder überschreitet..

2. System gemäß Anspruch 1, wobei die Maßnahme umfasst,
- Ausgeben eines Hinweises in Bezug auf die Güte der Steckverbindung über eine Ausgabeeinheit (103) des Hausgeräts (100);
- Reduzieren einer Leistungsaufnahme des Hausgeräts (100) über die Leistungsverbindungen (211, 221); und/oder
- Überführen des Hausgeräts (100) in einen sicheren Betriebszustand.

3. System gemäß einem der vorhergehenden Ansprüche, wobei das Signal auf der Signalleitung (217) abhängig ist, von:
- einem Übergangswiderstand zumindest einer der Leistungsverbindungen (211, 221);
- einer Wärmeentwicklung an zumindest einer der Leistungsverbindungen (211, 221); und/oder
- einem Überlappungsgrad zwischen den Leistungs-Kontaktteilen der geräteseitigen Schnittstelleneinheit (112) und den Leistungs-Kontaktteilen der Geräteschnittstelle (102).

4. System gemäß einem der vorhergehenden Ansprüche, wobei ein Leistungs-Kontaktteil der geräteseitigen Schnittstelleneinheit (112) eine Buchse umfasst, in die ein Stift der Geräteschnittstelle (102) gesteckt werden kann.

5. System gemäß einem der vorhergehenden Ansprüche, wobei die geräteseitige Schnittstelleneinheit (112) und die Geräteschnittstelle (102) Mittel umfassen, mit denen Information in Bezug auf die Güte der Steckverbindung zwischen der geräteseitigen Schnittstelleneinheit (112) und der Geräteschnittstelle (102) erfasst und über die Signalleitung (217) der Geräteschnittstelle (102) angezeigt werden kann.

6. System gemäß einem der vorhergehenden Ansprüche, wobei
- die ersten Mittel (213) einen ersten Optokoppler umfassen;
- der erste Optokoppler eine Lichtquelle umfasst, die eingerichtet ist, eine Menge an Licht zu generieren, die abhängig von dem Übergangswiderstand der ersten Leistungsverbindung (211) ist;
- der erste Optokoppler einen Phototransistor umfasst, der eingerichtet ist, das von der Lichtquelle generierte Licht zu empfangen und einen Durchlass-Widerstand des Phototransistors in Abhängigkeit von der empfangenen Menge an Licht zu ändern; und
- der Phototransistor angeordnet ist, um die Signalleitung (217) über den Durchlass-Widerstand mit einer Referenzleitung (227) zu koppeln.

7. System gemäß einem der vorhergehenden Ansprüche, wobei
- die geräteseitige Schnittstelleneinheit (112) und die Geräteschnittstelle (102) Mess-Kontaktteile aufweisen, um eine zweite Messverbindung (225) parallel zu einer zweiten Leistungsverbindung (221) der Leistungsverbindungen (211, 221) aufzubauen;
- die geräteseitige Schnittstelleneinheit (112) zweite Mittel (223) umfasst, die eingerichtet sind, über die zweite Messverbindung (225) Information in Bezug auf einen Übergangswiderstand der zweiten Leistungsverbindung (221) zu erfassen; und
- die geräteseitige Schnittstelleneinheit (112) Kombinations-Elektronik (201) umfasst, die eingerichtet ist, die Information in Bezug auf den Übergangswiderstand der ersten Leistungsverbindung (211) und die Information in Bezug auf den Übergangswiderstand der zweiten Leistungsverbindung (221) zu kombinieren und über die Signalleitung (217) bereitzustellen.

8. System gemäß einem der vorhergehenden Ansprüche, wobei
- die geräteseitige Schnittstelleneinheit (112) einen Temperatursensor (202) umfasst, der thermisch mit zumindest einer der Leistungsverbindungen (211, 221) gekoppelt ist; und
- die Signalleitung (217) dazu eingerichtet ist, Information in Bezug auf eine Temperatur des Temperatursensors (202) anzuzeigen.

9. System gemäß Anspruch 8, wobei
- die geräteseitige Schnittstelleneinheit (112) und die Geräteschnittstelle (102) Referenz-Kontaktteile (227) aufweisen, über die die geräteseitige Schnittstelleneinheit (112) mit einer Referenzleitung (227) der Geräteschnittstelle (102) verbunden werden kann; und
- der Temperatursensor (202) einen temperaturabhängigen Widerstand umfasst, der die Signalleitung (217) mit der Referenzleitung (227) verbindet.

10. System gemäß einem der vorhergehenden Ansprüche, wobei
- die geräteseitige Schnittstelleneinheit (112) und die Geräteschnittstelle (102) Referenz-Kontaktteile (227) aufweisen, über die die geräteseitige Schnittstelleneinheit (112) mit einer Referenzleitung (227) der Geräteschnittstelle (102) verbunden werden kann; und
- die geräteseitige Schnittstelleneinheit (112) eine elektrisch leitfähige Kontaktbrücke (300) umfasst, mit der die Signalleitung (217) mit der Referenzleitung (227) verbunden wird, wenn ein Überlappungsgrad zwischen den Leistungs-Kontaktteilen der geräteseitigen Schnittstelleneinheit (112) und den Leistungs-Kontaktteilen der Geräteschnittstelle (102) einen vordefinierten Überlappungsgrad-Schwellenwert erreicht oder überschreitet.

11. System gemäß einem der vorhergehenden Ansprüche, wobei
- die Geräteschnittstelle (102) eine Senke (321) aufweist, in die bei Herstellung der Steckverbindung zwischen der Geräteschnittstelle (102) und der geräteseitigen Schnittstelleneinheit (112) eine Nase (320) der geräteseitigen Schnittstelleneinheit (112) eintaucht;
- die Lichtquelle (311) und der Phototransistor (314) derart angeordnet sind, dass von der Lichtquelle (311) emittiertes Licht (313) quer durch die Senke (321) zu dem Phototransistor (314) gelangt; und
- die Nase (320) und die Senke (321) derart ausgebildet sind, dass die Nase (320) Licht (313), das von der Lichtquelle (311) emittiert wurde, von dem Phototransistor (314) abschirmt, wenn der Überlappungsgrad zwischen den Leistungs-Kontaktteilen der geräteseitigen Schnittstelleneinheit (112) und den Leistungs-Kontaktteilen der Geräteschnittstelle (102) einen vordefinierten Überlappungsgrad-Schwellenwert erreicht oder überschreitet.

## Claims

1. System comprising a household appliance (100) and a mains cable (110), wherein
- the mains cable (100) comprises an appliance-side interface unit (112), which is connected via lines (113) to a main-side interface unit (111) in order to connect the mains cable (110) to an electrical supply network;
- the household appliance (100) comprises an appliance interface (102) for the connection of the mains cable (110) and a control unit (101); wherein
- the appliance interface (102) is configured to form a plug-in connection with the appliance-side interface unit (112) of the mains cable (110);
- the appliance interface (102) comprises power-contact parts, which are configured to form power connections (211, 221) with power-contact parts of the appliance-side interface unit (112), in order to supply the household appliance (100) with electrical energy from an electrical supply network;
- the appliance interface (102) is configured to indicate a quality of the plug-in connection between appliance interface (102) and appliance-side interface unit (112) by means of a signal on a signal line (217); and
- the control unit (101) is configured to prompt a measure relating to the quality of the plug-in connection in the household appliance (100) as a function of the signal; and
- the appliance-side interface unit (112) of the mains cable (110) comprises power-contact parts, which are configured to form power connections (211, 221) with power-contact parts of the appliance interface (102); and
wherein
- the appliance-side interface unit (112) and the appliance interface (102) have measuring-contact parts, in order to form a first measurement connection (215) in parallel with a first power connection (211) of the power connections (211, 221), and the appliance-side interface unit (112) comprises first means (213), which are configured to acquire information relating to a transfer resistance of the first power connection (211) via the first measurement connection (225), and to provide said information via the signal line (217), **characterised in that**
- the appliance interface (102) comprises a light source (311), which is configured to emit light (313); and that
- the appliance interface (102) comprises a phototransistor (314), which is configured to couple the signal line (217) to a reference line (227) or uncouple it from the reference line (227) as a function of an acquired quantity of light (313); and that
- the appliance-side interface unit (112) and the appliance interface (102) are embodied such that the quantity of light (313) from the light source (311), which is acquired by the phototransistor (314), depends upon a degree of overlap between the power-contact parts of the appliance-side interface unit (112) and the power-contact parts of the appliance interface (102), and
- wherein the appliance-side interface unit (112) comprises a reflective layer (310), which is configured to reflect light (313) from the light source (311) to the phototransistor (314), if the degree of overlap between the power-contact parts of the appliance-side interface unit (112) and the power-contact parts of the appliance interface (102) reaches or exceeds a predefined threshold value for the degree of overlap.

2. System according to claim 1, wherein the measure comprises:
- outputting a note relating to the quality of the plug-in connection via an output unit (103) of the household appliance (100);
- reducing a power consumption of the household appliance (100) via the power connections (211, 221); and/or
- transferring the household appliance (100) into a secure operating state.

3. System according to one of the preceding claims, wherein the signal at the signal line (217) is dependent upon:
- a transfer resistance of at least one of the power connections (211, 221);
- a heat generation at at least one of the power connections (211, 221); and/or
- a degree of overlap between the power-contact parts of the appliance-side interface unit (112) and the power-contact parts of the appliance interface (102).

4. System according to one of the preceding claims, wherein a power-contact part of the appliance-side interface unit (112) comprises a bush, into which a pin of the appliance interface (102) can be plugged.

5. System according to one of the preceding claims, wherein the appliance-side interface unit (112) and the appliance interface (102) comprise means, with which information relating to the quality of the plug-in connection between the appliance-side interface unit (112) and the appliance interface (102) can be acquired and indicated via the signal line (217) of the appliance interface (102).

6. System according to one of the preceding claims, wherein
- the first means (213) comprise a first optocoupler;
- the first optocoupler comprises a light source, which is configured to generate a quantity of light, which is dependent upon the transfer resistance of the first power connection (211);
- the first optocoupler comprises a phototransistor, which is configured to receive the light generated by the light source and to change a forward resistance of the phototransistor as a function of the received quantity of light; and
- the phototransistor is arranged so as to couple the signal line (217) to a reference line (227) via the forward resistance.

7. System according to one of the preceding claims, wherein
- the appliance-side interface unit (112) and the appliance interface (102) have measuring-contact parts, in order to form a second measurement connection (225) in parallel with a second power connection (211) of the power connections (211, 221);
- the appliance-side interface unit (112) comprises second means (223), which are configured to acquire information relating to a transfer resistance of the second power connection (221) via the second measurement connection (225), and
- the appliance-side interface unit (112) comprises combined electronics (201), which are configured to combine the information relating to the transfer resistance of the first power connection (211) and the information relating to the transfer resistance of the second power connection (221) and to provide it via the signal line (217).

8. System according to one of the preceding claims, wherein
- the appliance-side interface unit (112) comprises a temperature sensor (202), which is thermally coupled to at least one of the power connections (211, 221); and
- the signal line (217) is configured to indicate information relating to a temperature of the temperature sensor (202).

9. System according to claim 8, wherein
- the appliance-side interface unit (112) and the appliance interface (102) have reference-contact parts (227), via which the appliance-side interface unit (112) is connected to a reference line (227) of the appliance interface (102); and
- the temperature sensor (202) comprises a temperature-dependent resistor, which connects the signal line (217) to the reference line (227).

10. System according to one of the preceding claims, wherein
- the appliance-side interface unit (112) and the appliance interface (102) have reference-contact parts (227), via which the appliance-side interface unit (112) can be connected to a reference line (227) of the appliance interface (102); and
- the appliance-side interface unit (112) comprises an electrically conductive contact bridge (300), by way of which the signal line (217) is connected to the reference line (227), if a degree of overlap between the power-contact parts of the appliance-side interface unit (112) and the power-contact parts of the appliance interface (102) reaches or exceeds a predefined threshold value for the degree of overlap.

11. System according to one of the preceding claims, wherein
- the appliance interface (102) has a sink (321), into which a lug (320) of the appliance-side interface unit (112) is immersed when producing the plug-in connection between the appliance interface (102) and the appliance-side interface unit (112);
- the light source (311) and the phototransistor (314) are arranged such that light (313) emitted by the light source (311) reaches the phototransistor (314) straight through the sink (321); and
- the lug (320) and the sink (321) are embodied such that the lug (320) shields light (313), which has been emitted by the light source (311), from the phototransistor (314), if the degree of overlap between the power-contact parts of the appliance-side interface unit (112) and the power-contact parts of the appliance interface (102) reaches or exceeds a predefined threshold value for the degree of overlap.

## Revendications

1. Système avec un appareil ménager (100) et un câble réseau (110), dans lequel
- le câble réseau (110) comprend une unité d'interface côté appareil (112) qui est relié par l'intermédiaire de lignes (113) à une unité d'interface côté réseau (111) destinée à la connexion du câble réseau (110) à un réseau d'alimentation électrique ;
- l'appareil ménager (100) comprend une interface d'appareil (102) destinée à la connexion du câble réseau (110) et une unité de commande (101) ; dans lequel
- l'interface d'appareil (102) est conçue pour former une connexion enfichable avec l'unité d'interface côté appareil (112) du câble réseau (110) ;
- l'interface d'appareil (102) comprend des parties de contact de puissance qui sont conçues pour former avec des pièces de contact de puissance de l'unité d'interface côté appareil (112) des liaisons de puissance (211, 221) pour alimenter l'appareil ménager (100) en énergie électrique en provenance d'un réseau d'alimentation électrique ;
- l'interface d'appareil (102) est conçue pour afficher au moyen d'un signal sur une ligne de signal (217) une qualité de la connexion enfichable entre l'interface d'appareil (102) et l'unité d'interface côté appareil (112) ; et
- l'unité de commande (101) est conçue pour ordonner, en fonction du signal, dans l'appareil ménager (100) une mesure par rapport à la qualité de la connexion enfichable ; et
- l'unité d'interface côté appareil (112) du câble réseau (110) comprend des parties de contact de puissance qui sont conçues pour former avec les parties de contact de puissance de l'interface d'appareil (102) les liaisons de puissance (211, 221), et
dans lequel
- l'unité d'interface côté appareil (112) et l'interface d'appareil (102) présentent des parties de contact de mesure pour former une première liaison de mesure (215) parallèlement à la première liaison de puissance (211) des liaisons de puissance (211, 221) et l'unité d'interface côté appareil (112) comprend des premiers moyens (213) qui sont conçus pour acquérir par l'intermédiaire de la première liaison de mesure (225) une information par rapport à une résistance de contact de la première liaison de puissance (211) et la mettre à disposition par l'intermédiaire de la ligne de signal (217), **caractérisé en ce que**
- l'interface d'appareil (102) comprend une source de lumière (311) qui est conçue pour émettre une lumière (313) ; et **en ce que**
- l'interface d'appareil (102) comprend un phototransistor (314) qui est conçu pour coupler la ligne de signal (217) en fonction d'une quantité acquise de lumière (313) à une ligne de référence (227) ou de la découpler de la ligne de référence (227) ; et **en ce que**
- l'unité d'interface côté appareil (112) et l'interface d'appareil (102) sont réalisées de telle sorte que la quantité de lumière (313) de la source de lumière (311) qui est acquise par le phototransistor (314) dépend d'un degré de chevauchement entre les parties de contact de puissance de l'unité d'interface côté appareil (112) et des parties de contact de puissance de l'interface d'appareil (102), et
- dans lequel l'unité d'interface côté appareil (112) présente une couche réfléchissante (310) qui est conçue pour réfléchir de la lumière (313) de la source de lumière (311) au niveau du phototransistor (314) lorsque le degré de chevauchement entre les parties de contact de puissance de l'unité d'interface côté appareil (112) et les parties de contact de puissance de l'interface d'appareil (102) atteint ou dépasse une valeur de seuil de degré de chevauchement prédéfinie.

2. Système selon la revendication 1, dans lequel la mesure comprend
- l'émission d'une indication par rapport à la qualité de la connexion enfichable par l'intermédiaire d'une unité d'émission (103) de l'appareil ménager (100) ;
- la réduction d'une absorption de puissance de l'appareil ménager (100) par l'intermédiaire des liaisons de puissance (211, 221) ; et/ou
- le passage de l'appareil ménager (100) dans un état de fonctionnement sûr.

3. Système selon l'une quelconque des revendications précédentes, dans lequel le signal sur la ligne de signal (217) dépend :
- d'une résistance de contact d'au moins une des liaisons de puissance (211, 221) ;
- d'une production de chaleur au niveau d'au moins une des liaisons de puissance (211, 221) ; et/ou
- d'un degré de chevauchement entre les parties de contact de puissance de l'unité d'interface côté appareil (112) et les parties de contact de puissance de l'interface d'appareil (102).

4. Système selon l'une quelconque des revendications précédentes, dans lequel une partie de puissance de l'unité d'interface côté appareil (112) comprend un connecteur femelle dans lequel une broche de l'interface d'appareil (102) peut être insérée.

5. Système selon l'une quelconque des revendications précédentes, dans lequel l'unité d'interface côté appareil (112) et l'interface d'appareil (102) comprennent des moyens avec lesquels une information par rapport à la qualité de la connexion enfichable entre l'unité d'interface côté appareil (112) et l'interface d'appareil (102) est acquise et peut être affichée par l'intermédiaire de la ligne de signal (217) de l'interface d'appareil (102).

6. Système selon l'une quelconque des revendications précédentes, dans lequel
- les premiers moyens (213) comprennent un premier optocoupleur ;
- le premier optocoupleur comprend une source de lumière qui est conçue pour générer une quantité de lumière qui dépend de la résistance de contact de la première liaison de puissance (211) ;
- le premier optocoupleur comprend un phototransistor qui est conçu pour recevoir la lumière générée par la source de lumière et modifier une résistance à l'état passant du phototransistor en fonction de la quantité de lumière reçue ; et
- le phototransistor est agencé pour coupler la ligne de signal (217) à une ligne de référence (227) par l'intermédiaire de la résistance à l'état passant.

7. Système selon l'une quelconque des revendications précédentes, dans lequel
- l'unité d'interface côté appareil (112) et l'interface d'appareil (102) présentent des parties de contact de mesure pour mettre en place une deuxième liaison de mesure (225) en parallèle à une deuxième liaison de puissance (221) des liaisons de puissance (211, 221) ;
- l'unité d'interface côté appareil (112) comprend des deuxièmes moyens (223) qui sont conçus pour acquérir par l'intermédiaire de la deuxième liaison de mesure (225) une information par rapport à une résistance de contact de la deuxième liaison de puissance (221) ; et
- l'unité d'interface côté appareil (112) comprend une électronique de combinaison (201) qui est conçue pour combiner l'information par rapport à la résistance de contact de la première liaison de puissance (211) et l'information par rapport à la résistance de contact de la deuxième liaison de puissance (221) et les mettre à disposition par l'intermédiaire de la ligne de signal (217).

8. Système selon l'une quelconque des revendications précédentes, dans lequel
- l'unité d'interface côté appareil (112) comprend un capteur de température (202) qui est couplé thermiquement à au moins une des liaisons de puissance (211, 221) ; et
- la ligne de signal (217) est conçue pour afficher une information par rapport à une température du capteur de température (202).

9. Système selon la revendication 8, dans lequel
- l'unité d'interface côté appareil (112) et l'interface d'appareil (102) présentent des parties de contact de référence (227) par l'intermédiaire desquelles l'unité d'interface côté appareil (112) peut être reliée à une ligne de référence (227) de l'interface d'appareil (102) ; et
- le capteur de température (202) comprend une résistance dépendante de la température qui relie la ligne de signal (217) à la ligne de référence (227).

10. Système selon l'une quelconque des revendications précédentes, dans lequel
- l'unité d'interface côté appareil (112) et l'interface d'appareil (102) présentent des parties de contact de référence (227) par l'intermédiaire desquelles l'unité d'interface côté appareil (112) peut être reliée à une ligne de référence (227) de l'interface d'appareil (102) ; et
- l'unité d'interface côté appareil (112) comprend un pont de contact électriquement conducteur (300) avec lequel la ligne de signal (217) est reliée à la ligne de référence (227) lorsqu'un degré de chevauchement entre les parties de contact de puissance de l'unité d'interface côté appareil (112) et les parties de contact de l'interface d'appareil (102) atteint ou dépasse une valeur de seuil de degré de chevauchement prédéfinie.

11. Système selon l'une quelconque des revendications précédentes, dans lequel
- l'interface d'appareil (102) présente un creux (321) dans lequel lors de la fabrication de la connexion enfichable entre l'interface d'appareil (102) et l'unité d'interface côté appareil (112) un bec (320) de l'unité d'interface côté appareil (112) plonge ;
- la source de lumière (311) et le phototransistor (314) sont disposés de telle sorte qu'une lumière (313) émise par la source de lumière (311) atteint le phototransistor (314) à travers le creux (321) ; et
- le bec (320) et le creux (321) sont configurés de telle sorte que le bec (320) protège la lumière (313) qui a été émise par la source de lumière (311) contre le phototransistor (314) lorsque le degré de chevauchement entre les parties de contact de puissance de l'unité d'interface côté appareil (112) et les parties de contact de puissance de l'interface d'appareil (102) atteint ou dépasse une valeur de seuil de degré de chevauchement prédéfinie.
